(19) Europäisches Patentamt
European Patent Office
Office européen des brevets

(11) **EP 4 764 533 A1**

(12) **EUROPEAN PATENT APPLICATION**
published in accordance with Art. 153(4) EPC

(43) Date of publication:
**24.06.2026  Bulletin 2026/26**

(21) Application number: 25864542.3

(22) Date of filing: **09.07.2025**

(51) International Patent Classification (IPC):
*G01R 31/382* (2019.01)    *G01R 31/396* (2019.01)
*G01R 31/367* (2019.01)    *G01R 31/36* (2020.01)
*G01R 19/165* (2006.01)    *H02J 7/00* (2026.01)

(52) Cooperative Patent Classification (CPC):
**G01R 19/165; G01R 31/36; G01R 31/367;
G01R 31/382; G01R 31/396; H02J 7/00**

(86) International application number:
**PCT/KR2025/009917**

(87) International publication number:
**WO 2026/071422 (02.04.2026 Gazette 2026/14)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **26.09.2024  KR 20240130707**

(71) Applicant: **LG Energy Solution, Ltd.
Seoul 07335 (KR)**

(72) Inventor: **LEE, Hyun Chul
Daejeon 34122 (KR)**

(74) Representative: **Plasseraud IP
104 Rue de Richelieu
CS92104
75080 Paris Cedex 02 (FR)**

(54) **BATTERY MANAGEMENT APPARATUS AND METHOD THEREOF**

(57)    A battery management device according to an embodiment of this document includes a memory configured to store one or more instructions and a processor configured to execute the one or more instructions, and the processor is configured to acquire a reference voltage for determining initial driving batteries among a plurality of batteries based on factors acquired from a plurality of cells included in each of the plurality of batteries, and manage a connection state of each of the plurality of batteries based on the reference voltage.

```
┌─────────────────────────────────────────┐
│  BATTERY MANAGEMENT DEVICE               │
│              200                         │
│   ┌───────────────────────────────────┐ │
│   │         PROCESSOR                 │ │
│   │            210                    │ │
│   └───────────────────────────────────┘ │
│   ┌───────────────────────────────────┐ │
│   │          MEMORY                   │ │
│   │            220                    │ │
│   └───────────────────────────────────┘ │
└─────────────────────────────────────────┘
```

FIG.2

EP 4 764 533 A1

**Description**

## TECHNICAL FIELD

CROSS-REFERENCE TO RELATED APPLICATIONS

This application claims priority from Korean Patent Application No. 10-2024-0130707, filed on September 26, 2024, the disclosure of which is incorporated by reference herein.

TECHNICAL FIELD

Embodiments disclosed in this document relate to a battery management device and battery management method.

## BACKGROUND ART

Recently, research and development on secondary batteries have been actively conducted. Here, secondary batteries are batteries that can be charged and discharged, and may be interpreted as including both conventional Ni/Cd batteries, Ni/MH batteries, and recent lithium-ion batteries. Recently, the scope of use of the secondary batteries has expanded to include a power source for electric vehicles, and the secondary batteries are attracting attention as a next-generation energy storage medium.

In particular, various methods for determining an initial driving battery among a plurality of batteries in a device including the plurality of batteries are being studied. When a voltage difference between batteries is large, the efficiency of a battery system including the batteries decreases, and various studies are being conducted to solve this problem.

## DISCLOSURE OF THE INVENTION

## TECHNICAL PROBLEM

Embodiments provide a battery management device and battery management method that determines an initial driving battery among a plurality of batteries.

Embodiments provide a battery management device and battery management method that determines an initial driving battery by comparing a difference between a voltage of a reference battery among a plurality of batteries and a voltage between the remaining batteries.

Embodiments provide a battery management device and battery management method that determines a reference voltage using factors acquired from battery cells and determining an initial driving battery using a voltage of each of a plurality of batteries and the reference voltage.

The technical problems of the embodiments disclosed in this document are not limited to the technical problems mentioned above, and other technical problems that are not mentioned may be clearly understood by those skilled in the art from the descriptions below.

## TECHNICAL SOLUTION

A battery management device according to an embodiment of this document includes a memory configured to store one or more instructions and a processor configured to execute the one or more instructions, and the processor is configured to acquire a reference voltage for determining initial driving batteries among a plurality of batteries based on factors acquired from a plurality of cells included in each of the plurality of batteries, and manage a connection state of each of the plurality of batteries based on the reference voltage.

In an embodiment, the factors may include a nominal resistance of the plurality of cells, an allowable operating current of the plurality of cells, a first number of the plurality of cells connected in parallel, and an allowable voltage of the plurality of batteries.

In an embodiment, the processor may be configured to acquire the allowable voltage based on the nominal resistance, the operating current, and the first number.

In an embodiment, the processor may be configured to acquire the reference voltage based on the operating current, the first number, a second number of the plurality of cells connected in series, and the allowable voltage.

In an embodiment, the processor may be configured to determine whether to connect the at least one battery to the reference battery based on whether a difference between a first voltage of a reference battery and a second voltage of at least one battery different from the reference battery among the plurality of batteries is less than the reference voltage.

In an embodiment, the processor may be configured to connect the at least one battery to the reference battery based on the difference between the first voltage and the second voltage being less than the reference voltage.

In an embodiment, the processor may be configured to disconnect a connection between the at least one battery and the reference battery based on a difference between the first voltage and the second voltage being greater than or equal to the reference voltage.

In an embodiment, the plurality of batteries may include at least one of a plurality of battery packs, a plurality of battery racks, or any combination thereof.

A battery management method according to an embodiment of this document includes an operation of acquiring, by a processor, a reference voltage for determining initial driving batteries among a plurality of batteries based on factors acquired from a plurality of cells included in each of the plurality of batteries, and an operation of managing, by the processor, a connection state of each of the plurality of batteries based on the reference voltage.

In an embodiment, the factors may include a nominal resistance of the plurality of cells, an allowable operating current of the plurality of cells, a first number of the plurality of cells connected in parallel, and an allowable voltage of the plurality of batteries.

The battery management method according to an embodiment of this document may include an operation of acquiring the allowable voltage based on the nominal resistance, the operating current, and the first number.

The battery management method according to an embodiment of this document may include an operation of acquiring the reference voltage based on the operating current, the first number, a second number of the plurality of cells connected in series, and the allowable voltage.

The battery management method according to an embodiment of this document may include an operation of determining whether to connect the at least one battery to the reference battery based on whether a difference between a first voltage of a reference battery and a second voltage of at least one battery different from the reference battery among the plurality of batteries is less than the reference voltage.

The battery management method according to an embodiment of this document may include an operation of connecting the at least one battery to the reference battery based on the difference between the first voltage and the second voltage being less than the reference voltage.

The battery management method according to an embodiment of this document may include an operation of disconnecting a connection between the at least one battery and the reference battery based on a difference between the first voltage and the second voltage being greater than or equal to the reference voltage.

## ADVANTAGEOUS EFFECTS

The present technology can determine an initial driving battery among a plurality of batteries.

In addition, the present technology can determine an initial driving battery by comparing a difference between a voltage of a reference battery among a plurality of batteries and voltages of the remaining batteries.

In addition, the present technology can determine a reference voltage using factors acquired from battery cells and determine an initial driving battery using a voltage of each of a plurality of batteries and the reference voltage.

In addition, various effects directly or indirectly identified through this document may be provided.

## BRIEF DESCRIPTION OF THE DRAWINGS

FIG. 1 is a block diagram illustrating a battery pack, in a battery management device and battery management method according to an embodiment of this document.
FIG. 2 illustrates an example of a block diagram illustrating a configuration of a battery management device according to an embodiment of this document.
FIG. 3 illustrates an example of a plurality of batteries according to an embodiment of this document.
FIG. 4 illustrates an example of a flowchart related to a battery management method according to an embodiment of this document.
FIG. 5 is a block diagram illustrating a hardware configuration of a computing system that performs a battery management method, in a battery management device and battery management method according to an embodiment of this document.

## MODE FOR CARRYING OUT THE INVENTION

Hereinafter, some embodiments described in this document are described with reference to the accompanying drawings. However, this is not intended to limit the present technology to a specific embodiment, but should be understood to include various modifications, equivalents, and/or alternatives of the embodiments of the present technology.

When adding reference numerals to components in each drawing, it should be noted that the same components are given the same reference numerals as much as possible even if they are shown in different drawings. In addition, when describing various embodiments disclosed in this document, if a specific description of a related known configuration or function is determined to hinder understanding of the embodiments of the present disclosure, the detailed description thereof is omitted. A singular form of a noun corresponding to an item may include one item or a plurality of items unless the relevant context clearly indicates otherwise.

In describing the components of the embodiments of this document, terms such as first, second, A, B, (a), (b), etc. may be used. These terms are only intended to distinguish the components from other components, and the nature, order, or sequence of the components are not limited by the terms. In addition, unless otherwise defined, all terms used herein, including technical or scientific terms, have the same meaning as generally understood by a person having ordinary skill in the art to which the embodiments disclosed in this document belong. Terms defined in commonly used dictionaries should be interpreted as having a meaning consistent with the meaning they have in the context of the relevant technology, and shall not be interpreted in an ideal or excessively formal sense unless explicitly defined in this application.

In addition, in the present disclosure, expressions of "more than" or "less than" may be used to determine whether a specific condition is satisfied or fulfilled, but this is only a description for expressing an example and does not exclude descriptions of "greater than or equal to" or "less than or equal to". A condition described as "greater than or equal to" may be replaced with "more than", a condition described as "less than or equal to" may be replaced with "less than", and a condition described as "greater than or equal to and less than" may be replaced with "more than and less than or equal to". In addition, hereinafter, "A" to "B" mean at least one of the elements from A (including A) to B (including B).

In this document, each of phrases "A or B", "at least one of A and B", "at least one of A or B", "A, B, or C", "at least one of A, B, and C", and "at least one of A, B, or C" may include any one of the items listed together in the corresponding phrase among the phrases, or all possible combinations thereof.

In this document, when a component (e.g., a first component) is referred to as being "connected", "coupled" or "joined" to another component (e.g., a second component), with or without the terms "functionally" or "communicatively", it means that the component can be connected to the other component directly (e.g., in a wired manner), wirelessly, or through a third component.

The method according to the various embodiments disclosed in this document may be provided by being included in a computer program product. The computer program product may be traded between a seller and a buyer as a product. The computer program product may be distributed in the form of a machine-readable recording medium (e.g., compact disc read only memory (CD-ROM)), or distributed through an application store, distributed directly between two user devices, or distributed online (e.g., downloaded or uploaded). In the case of online distribution, at least a part of the computer program product may be temporarily stored or temporarily generated in a machine-readable recording medium, such as a memory of a manufacturer's server, an application store's server, or a relay server.

According to various embodiments, each of the components (e.g., modules or programs) described above may include a single or plurality of entities, and some of the plurality of entities may be separated and placed in other components. According to various embodiments, one or more of the components or operations described above may be omitted, or one or more other components or operations may be added. Alternatively or additionally, a plurality of components (e.g., modules or programs) may be integrated into a single component. In such a case, the integrated component may perform one or more functions of each of the plurality of components identically or similarly to those performed by the corresponding component among the plurality of components prior to the integration. According to various embodiments, the operations performed by a module, program, or other component may be performed sequentially, in parallel, repeatedly, or heuristically, or one or more of the operations may be performed in a different order, omitted, or performed by adding one or more other operations.

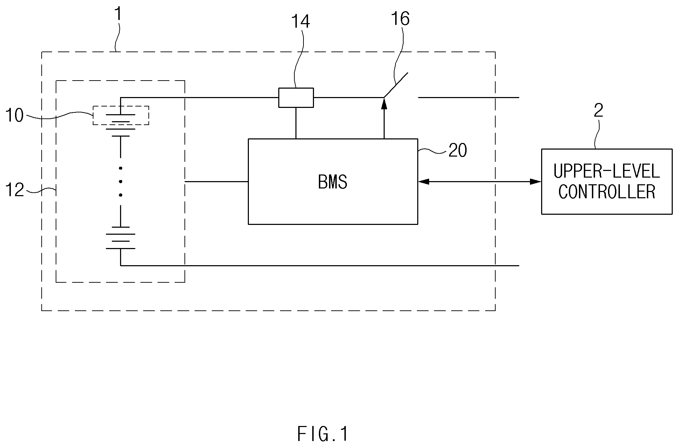

Hereinafter, embodiments of this document will be described in detail with reference to FIGS. 1 to 5.

FIG. 1 is a block diagram showing a battery pack, in a battery management device and battery management method according to an embodiment of this document.

Referring to FIG. 1, a battery pack 1 may include a battery unit 12, a sensor unit 14, a switching unit 16, and a battery management system (BMS) 20. In this case, the battery pack 1 may be equipped with a plurality of battery units 12, sensor units 14, switching units 16, and battery management systems 20.

According to an embodiment, the battery unit 12 may supply power to a target device (not shown). To this end, the battery unit 12 may be electrically connected to the target device. Here, the target device may include an electrical, electronic, or mechanical device that operates by receiving power from the battery pack 1. For example, the target device may be, but is not limited to, an electric vehicle (EV).

According to an embodiment, the battery unit 12 may include at least one battery cell 10 that is chargeable and dischargeable. Here, the battery cell 10 may be a basic unit of a battery cell that can be used by charging and discharging electric energy. For example, the battery cell 10 may be a lithium-ion (Li-ion) battery, a lithium-ion polymer battery, a nickel-cadmium (Ni-Cd) battery, a nickel-metal hydride (Ni-MH) battery, etc., but is not limited thereto.

According to an embodiment, a plurality of battery units 12 may be connected in series or in parallel. For example, the battery unit 12 may be a battery module, a battery bank, or a set of battery cells (cell-to-pack structure).

According to an embodiment, the sensor unit 14 may acquire information related to the battery unit 12. According to an embodiment, the sensor unit 14 may acquire values (or information) related to a state of each of the battery units 12 or battery cells 10. In an embodiment, the values related to the state may include one or more values for a voltage, a current, a resistance, a state of charge (SOC), a state of health (SOH), or a temperature of the battery cell, or a combination thereof.

According to an embodiment, the sensor unit 14 may provide information on each of the plurality of battery units 12 to the battery management system 20.

According to an embodiment, the switching unit 16 may include a device for controlling a current flow for charging or discharging the battery unit 12. For example, the switching unit 16 may include at least one relay and/or magnetic contactor, etc., depending on the specifications of the battery pack 1.

According to an embodiment, the battery management system (BMS) 20 may control or manage the battery pack 1 to prevent overcharge and overdischarge, etc. by monitoring the voltage, current, temperature, etc. of the battery pack 1. For example, the battery management system 20 is an interface that receives values acquired by measuring various parameters described above, and may include a plurality of terminals, a circuit connected to these terminals to process the received values, etc. In addition, the battery management system 20 may control the sensor unit 14 and/or the switching unit 16. For example, the battery management system 20 may be connected to a plurality of battery units 12 to monitor the state of each of the plurality of battery units 12 and control ON/OFF of a relay or contactor, etc.

According to an embodiment, an operation of the battery management system 20 may be performed by a battery management system (BMS) in a vehicle, and may also be performed in various devices such as a server, a cloud, a charger, or a charger/discharger.

An upper-level controller 2 may transmit a control signal for the plurality of battery units 12 to the battery management system 20. Accordingly, the operation of the battery management system 20 may be controlled based on a signal applied from the upper-level controller 2.

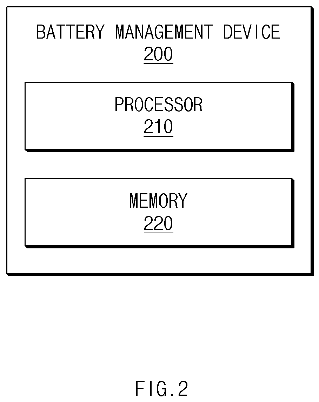

According to an embodiment, the battery management system 20 may include a battery management device 200 of FIG. 2. According to another embodiment, the battery management system 20 may be a different system from the battery management device 200 of FIG. 2. That is, the battery management device 200 of FIG. 2 may be included in the battery pack 1 or may be configured as another device external to the battery pack 1. Hereinafter, for convenience of description, the description will be made on the assumption that the battery management device 200 is composed of another device external to the battery pack 1. In addition, the operation of the battery management device 200 described below may be performed by a BMS in the vehicle, and may also be performed by various devices such as a server, a cloud, a charger, or a discharger.

FIG. 2 illustrates an example of a block diagram illustrating the configuration of a battery management device according to an embodiment of this document.

Referring to FIG. 2, the battery management device 200 according to an embodiment may include a processor 210 and a memory 220. The processor 210 and the memory 220 may be electrically and/or operably coupled with each other by an electronic component including a communication bus.

Hereinafter, operably coupling pieces of hardware with each other may include a direct connection and/or an indirect connection between pieces of hardware being established in a wired manner and/or wirelessly, such that a second piece of hardware is controlled by a first piece of hardware among the pieces of hardware.

Although pieces of hardware are illustrated in different blocks, embodiments are not limited thereto. For example, some of the pieces of hardware of FIG. 2 may be included in a single integrated circuit including a system on a chip (SoC). The type and/or number of pieces of hardware included in the battery management device 200 is not limited to that shown in FIG. 2. For example, the battery management device 200 may include only some pieces of the hardware shown in FIG. 2.

The battery management device 200 according to an embodiment may include hardware for processing data based on one or more instructions. The hardware for processing data may include the processor 210.

For example, the hardware for processing data may include an arithmetic and logic unit (ALU), a floating point unit (FPU), a field programmable gate array (FPGA), a central processing unit (CPU), and/or an application processor (AP). The processor 210 may have a single-core processor architecture or a multi-core processor architecture having dual cores, quad cores, hexa cores, or octa cores.

The memory 220 of the battery management device 200 according to an embodiment may include hardware components for storing data and/or instructions input and/or output to and from the processor 210 of the battery management device 200.

For example, the memory 220 may include a volatile memory including random-access memory (RAM) and/or a non-volatile memory including a read-only memory (ROM).

For example, the volatile memory may include at least one of dynamic RAM (DRAM), static RAM (SRAM), cache RAM, pseudo-SRAM (PSRAM), or any combination thereof.

For example, the non-volatile memory may include at least one of a programmable ROM (PROM), an erasable PROM (EPROM), an electrically erasable PROM (EEPROM), a flash memory, a hard disk, a compact disc, a solid state drive (SSD), an embedded multi-media card (eMMC), or any combination thereof.

For example, one or more instructions (or commands) indicating operations and/or actions to be performed on data by the processor 210 of the battery management device 200 may be stored in the memory 220 of the battery management device 200. A set of one or more instructions may be referred to as a program, firmware, operating system, process, routine, subroutine, and/or application. Hereinafter, the installation of an application in the battery management device 200 may mean that one or more instructions provided in the form of an application are stored in the memory 220, and that one or more applications are stored in an executable format (e.g., a file having an extension specified by an operating system of the battery management device 200) by the processor 210 of the battery management device 200.

According to an embodiment, the processor 210 of the battery management device 200 may acquire factors from a plurality of cells included in each of the plurality of batteries. For example, the factors may include at least one of the nominal resistance of the plurality of cells, the allowable operating current of the plurality of cells, the number of cells connected in parallel, the allowable voltage of the plurality of batteries, or any combination thereof. For example, the plurality of batteries may include at least one of a plurality of battery packs, a plurality of battery racks, or any combination thereof.

For example, the processor 210 may acquire a reference voltage for determining an initial driving battery among the plurality of batteries based on the factors acquired from the plurality of cells included in each of the plurality of batteries.

For example, the initial driving batteries may include initial batteries that supply voltage and/or current to a device when the device is powered by the battery.

For example, the processor 210 may manage a connection state of each of the plurality of batteries based on the reference voltage for determining the initial driving batteries among the plurality of batteries.

For example, the processor 210 may connect the determined initial driving batteries based on the determination of the initial driving batteries among the plurality of batteries.

In an embodiment, the processor 210 may acquire an allowable voltage based on at least one of the nominal resistance, the operating current, the number of cells connected in parallel, or any combination thereof. For example, the processor 210 may acquire an allowable voltage based on the nominal resistance, the operating current, and the number of cells connected in parallel.

For example, the processor 210 may acquire an allowable voltage based on Equation 1 below.

[Equation 1]

$$Cell_{entry_{voltage}} = Cell_{op_{current}} \times \left( \frac{1}{\dfrac{Cell_{parallel}}{Cell_{internal_{resistor}}}} \right)$$

In Equation 1, $Cell_{entry_{voltage}}$ may represent the allowable voltage. In Equation 1, $Cell_{op_{current}}$ may represent the operating current. In Equation 1, $Cell_{parallel}$ may represent the number of cells connected in parallel. In Equation 1, $Cell_{internal_{resistor}}$ may represent the nominal resistance. As described above, the processor 210 of the battery management device 200 according to an embodiment may acquire the allowable voltage based on Equation 1.

In an embodiment, the processor 210 may acquire a reference voltage based on at least one of the operating current, the number of cells connected in parallel, the allowable voltage, or any combination thereof. For example, the processor 210 may acquire the reference voltage based on the operating current, the number of cells connected in parallel, and the allowable voltage. For example, the processor 210 may acquire the reference voltage based on Equation 2 below.

[Equation 2]

$$Allowble\_Rack\_Volt = Cell_{entry_{voltage}} \times Current_{ratio} \times Cell_{series}$$

For example, in Equation 2, *Allowble_Rack_Volt* may represent a reference voltage. For example, in Equation 2, $Cell_{entry_{voltage}}$ may represent an allowable voltage. For example, in Equation 2, $Current_{ratio}$ may represent a ratio of the allowable current of a plurality of cells connected in parallel included within the battery to the allowable current of a device including the battery. For example, in Equation 2, $Cell_{series}$ may represent the number of cells connected in series.

For example, in Equation 2, $Current_{ratio}$ may be acquired using Equation 3 described below.

[Equation 3]

$$Current_{ratio} = \frac{Rack_{op_{current}}}{Cell_{op_{current}} \times Cell_{parallel}}$$

For example, in Equation 3, $Current_{ratio}$ may represent the ratio of the allowable current of the plurality of cells connected in parallel included within the battery to the allowable current of the device including the battery. For example, in Equation 3, $Cell_{opcurrent}$ may represent the operating current. For example, in Equation 3, $Cell_{parallel}$ may represent the number of cells connected in parallel.

As described above, the processor 210 of the battery management device 200 according to an embodiment may acquire a reference voltage based on at least one of the allowable voltage, the ratio of the allowable current of the plurality of cells connected in parallel included within the battery to the allowable current of the device including the battery, the number of cells connected in series, the operating current, the number of cells connected in parallel, or any combination thereof. Specifically, the processor 210 may acquire the reference voltage based on the allowable voltage, the ratio of the allowable current of the plurality of cells connected in parallel included within the battery to the allowable current of the device including the battery, the number of cells connected in series, the operating current, and the number of cells connected in parallel.

In an embodiment, the processor 210 may determine whether a difference between a first voltage of a reference battery and a second voltage of at least one battery different from the reference battery among a plurality of batteries is less than the reference voltage. For example, the processor 210 may determine whether to connect at least one battery to the reference battery based on whether the difference between the first voltage of the reference battery and the second voltage of at least one battery among the plurality of batteries is less than the reference voltage.

In an embodiment, the processor 210 may identify that the difference between the first voltage and the second voltage is less than the reference voltage. For example, the processor 210 may connect at least one battery to the reference battery based on the difference between the first voltage and the second voltage being less than the reference voltage.

For example, the reference battery and at least one battery connected to the reference battery may be included in the initial driving batteries.

In an embodiment, the processor 210 may identify that the difference between the first voltage and the second voltage is greater than or equal to the reference voltage. For example, the processor 210 may disconnect the connection between the at least one battery and the reference battery based on the difference between the first voltage and the second voltage being greater than or equal to the reference voltage.

In an embodiment, the processor 210 may determine the reference battery from among a plurality of batteries, and acquire an average voltage of the first voltage and the second voltage of at least one battery different from the reference battery when the difference between the first voltage of the reference battery and the second voltage is less than the reference voltage. The processor 210 may identify the case where the average voltage is the highest, and determine a plurality of batteries in that case as initial driving batteries.

In an embodiment, the processor 210 may identify the number of reference batteries and at least one battery when the difference between the first voltage of the reference battery and the second voltage of at least one battery is less than the reference voltage. For example, the processor 210 may change the reference battery among a plurality of batteries, identify the number of reference batteries and at least one battery, and determine the initial driving battery based on the identified number of batteries. For example, the processor 210 may determine the reference battery and the at least one battery with the largest number as the initial driving battery. When the above-described numbers are equal, the processor 210 may determine a combination with the highest average voltage of the first voltage and the second voltage as the initial driving battery.

As described above, the battery management device 200 according to an embodiment may determine the initial driving battery based on the difference between the voltages of the plurality of batteries and supply power to the device using the determined initial driving battery. By performing the above processes, it is possible to select a case with the best use efficiency of the battery when using the battery.

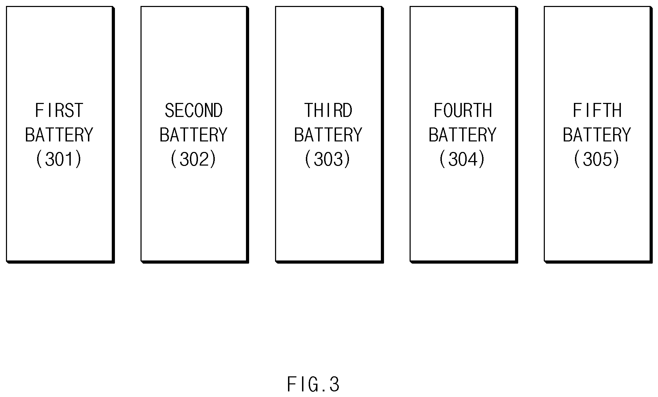

FIG. 3 illustrates an example of a plurality of batteries according to an embodiment of this document.

Referring to FIG. 3, the processor 210 of the battery management device 200 according to an embodiment may identify the voltage of each of a plurality of batteries 301, 302, 303, 304, and 305. For example, the processor 210 may use the plurality of batteries 301, 302, 303, 304, and 305 to acquire a reference voltage, and use the acquired reference voltage to determine the initial driving batteries, thereby managing the connection state of each of the plurality of batteries 301, 302, 303, 304, and 305.

In FIG. 3, the voltage of the first battery 301 is assumed to be approximately 800 V. In FIG. 3, the voltage of the second battery 302 is assumed to be approximately 785 V. In FIG. 3, the voltage of the third battery 303 is assumed to be approximately 790 V. In FIG. 3, the voltage of the fourth battery 304 is assumed to be approximately 795 V. In FIG. 3, the voltage of the fifth battery 305 is assumed to be approximately 775 V. In addition, the reference voltage acquired by the plurality of batteries 301, 302, 303, 304, and 305 illustrated in FIG. 3 is assumed to be approximately 7.056 V.

Referring to the above assumption, when the first battery 301 is determined as the reference battery, it may be confirmed that the battery having a voltage difference less than the reference voltage from the first battery 301 is the fourth battery 304. When the first battery 301 and the fourth battery 304 are connected to each other, it may be confirmed that the average voltage is approximately 797.5 V.

When the second battery 302 is determined as the reference battery, it may be confirmed that the battery having a voltage difference less than the reference voltage from the second battery 302 is the third battery 303. When the second battery 302 and the third battery 303 are connected to each other, it may be confirmed that the average voltage is approximately 787.5 V.

When the third battery 303 is determined as the reference battery, it may be confirmed that the batteries having a voltage difference less than the reference voltage from the third battery 303 are the second battery 302 and the fourth battery 304. When the second battery 302, the third battery 303, and the fourth battery 304 are connected to one another, it may be confirmed that the average voltage is approximately 790 V.

When the fourth battery 304 is determined as the reference battery, it may be confirmed that the batteries having a voltage difference less than the reference voltage from the fourth battery 304 are the first battery 301 and the third battery 303. When the first battery 301, the third battery 303, and the fourth battery 304 are connected to one another, it may be confirmed that the average voltage is approximately 795 V.

When the fifth battery 305 is determined as the reference battery, it may be confirmed that there are no batteries having a voltage difference less than the reference voltage from the fifth battery 305. Therefore, when the fifth battery 305 is used as the reference battery, only the fifth battery 305 may be determined as the initial driving battery.

Referring to the matters described above, the processor 210 of the battery management device 200 may determine a reference battery among the plurality of batteries 301, 302, 303, 304, and 305 and acquire an average voltage when determining the initial driving batteries using that battery. The processor 210 may connect the batteries by selecting the case where the average voltage is the highest. In the above example, as the highest average voltage is acquired when connecting the batteries by determining the fourth battery 304 as the reference battery, the processor 210 of the battery management device 200 may connect the first battery 301, the third battery 303, and the fourth battery 304 and use them as the initial driving batteries.

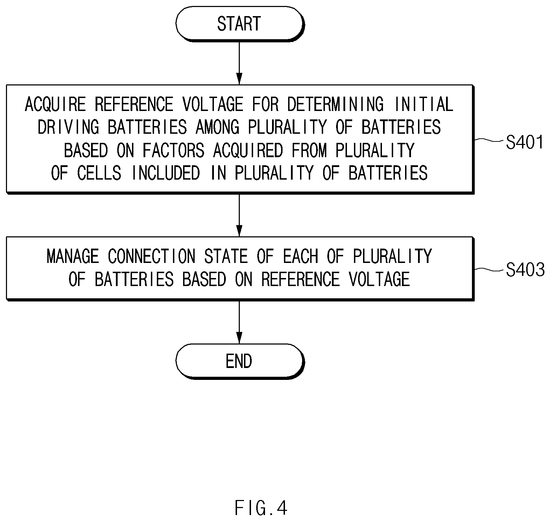

FIG. 4 illustrates an example of a flowchart related to a battery management method according to an embodiment of this document.

Hereinafter, it is assumed that the battery management device 200 of FIG. 2 performs a process of FIG. 4. In addition, in the description of FIG. 4, the operations described as being performed by the device may be understood as being controlled by the processor 210 of the battery management device 200.

At least one of the operations of FIG. 4 may be performed by the battery management device 200 of FIG. 2. At least one of the operations of FIG. 4 may be controlled by the processor 210 of FIG. 2. Each of the operations of FIG. 4 may be performed sequentially, but is not necessarily performed sequentially. For example, the order of the operations may be changed, and at least two operations may be performed in parallel.

Referring to FIG. 4, a battery management method according to an embodiment may include, in operation S401, an operation of acquiring a reference voltage for determining initial driving batteries among a plurality of batteries based on factors acquired from a plurality of cells included in the plurality of batteries.

For example, the plurality of batteries may include at least one of a plurality of battery packs, a plurality of battery racks, or any combination thereof.

For example, the factors may include the nominal resistance of the plurality of cells, the allowable operating current of the plurality of cells, the first number of cells connected in parallel, and the allowable voltage of the plurality of batteries.

For example, the battery management method may include an operation of acquiring an allowable voltage based on the nominal resistance, the operating current, and the first number.

For example, the battery management method may include an operation of acquiring a reference voltage based on the operating current, the first number, the second number of cells connected in series, and the allowable voltage.

In operation S403, the battery management method according to an embodiment may include an operation of managing a connection state of each of the plurality of batteries based on the reference voltage.

For example, the battery management method may include an operation of comparing a difference between a first voltage of a reference battery and a second voltage of at least one battery different from the reference battery among the plurality of batteries.

For example, the battery management method may include an operation of identifying whether the difference between the first voltage of the reference battery and the second voltage of at least one battery different from the reference battery among the plurality of batteries is less than the reference voltage.

For example, the battery management method may include an operation of determining whether to connect at least one battery to the reference battery based on whether the difference between the first voltage of the reference battery and the second voltage of at least one battery different from the reference battery among the plurality of batteries is less than the reference voltage.

For example, the battery management method may include an operation of identifying that the difference between the first voltage and the second voltage is less than the reference voltage.

For example, the battery management method may include an operation of connecting the at least one battery to the reference battery based on the difference between the first voltage and the second voltage being less than the reference voltage.

For example, the battery management method may include an operation of determining batteries having a voltage difference less than the reference voltage as initial driving batteries based on the difference between the first voltage and the second voltage being less than the reference voltage and connecting between the two.

For example, the battery management method may include an operation of identifying that the difference between the first voltage and the second voltage is greater than or equal to the reference voltage.

For example, the battery management method may include an operation of disconnecting the connection between the at least one battery and the reference battery based on the difference between the first voltage and the second voltage being greater than or equal to the reference voltage.

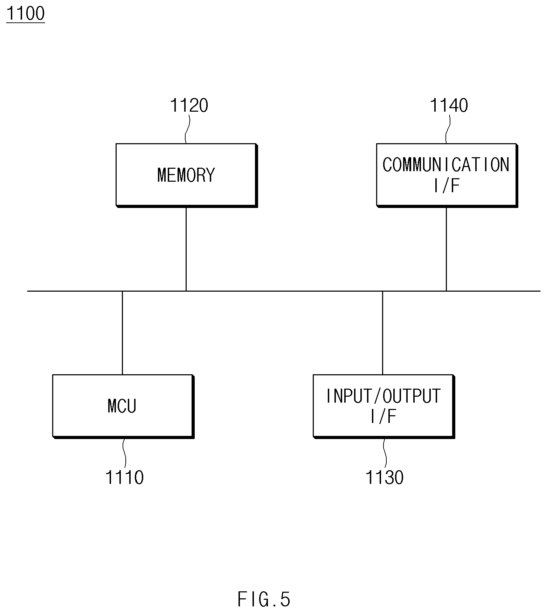

FIG. 5 is a block diagram illustrating a hardware configuration of a computing system that performs a battery management method, in a battery management device and battery management method according to an embodiment of this document.

Referring to FIG. 5, a computing system 1100 according to an embodiment disclosed in this document may include an MCU 1110, a memory 1120, an input/output I/F 1130, and a communication I/F 1140.

The MCU 1110 may be one or more processors that executes various programs (e.g., battery cell data collection program, graph generation program, data analysis program, data decomposition algorithm, normalization program, and battery cell diagnosis program, etc.) stored in the memory 1120, processes various information including characteristic data of the battery cell, latent variables, etc. through these programs, and performs the functions of the battery management device 200 shown in FIGS. 1 to 4 described above.

The memory 1120 may store various programs such as the battery cell data collection program, the graph generation program, the data analysis program, the data decomposition algorithm, the normalization program, and the battery cell diagnosis program.

A plurality of such memories 1120 may be provided as needed. The memory 1120 may be a volatile memory or a nonvolatile memory. The memory 1120 used as the volatile memory may be RAM, DRAM, SRAM, etc. The memory 1120 used as the nonvolatile memory may be ROM, PROM, EAROM, EPROM, EEPROM, flash memory, etc. The examples of the memories 1120 listed above are only examples, but are not limited to these examples.

The input/output I/F 1130 may provide an interface that allows data to be transmitted and received by connecting an input device (not shown) such as a keyboard, mouse, or touch panel and an output device (not shown) such as a display with the MCU 1110.

The communication I/F 1140 is a configuration that can transmit and receive various data with the server, and may be various devices that can support wired or wireless communication. For example, the battery management device 200 may transmit and receive various information including shape models of battery cells, etc. to and from a separately provided external server through the communication I/F 1140.

In this way, the computer program according to an embodiment disclosed in this document may be implemented as a module that performs, for example, each function shown in FIG. 2, by being recorded in the memory 1120 and processed by the MCU 1110.

In the above, even though all the components constituting the embodiments disclosed in this document have been described as being combined as one or operating in combination, the embodiments disclosed in this document are not necessarily limited to such embodiments. That is, within the scope of the purpose of the embodiments disclosed in this document, all of the components may be selectively combined and operated in one or more combinations.

In addition, the terms "include," "configure," or "have" described above, unless specifically stated to the contrary, mean that the corresponding component may be included, and therefore should be interpreted as being able to further include other components rather than excluding other components. All terms including technical or scientific terms have the same meaning as commonly understood by a person skilled in the art to which the embodiments disclosed in this document belong, unless otherwise defined. Terms commonly used, such as terms defined in the dictionary, should be interpreted as being consistent with the contextual meaning of the relevant technology, and should not be interpreted in an idealized or overly formal sense unless clearly defined in this document.

The above-mentioned disclosure outlines the features of several embodiments so that those skilled in the art may better understand aspects of the present disclosure. Those skilled in the art will understand that the present disclosure may be easily used as a basis for designing or changing different structures to perform the same purpose or achieve the same advantages of embodiments introduced in this document. Furthermore, those skilled in the art will recognize that such equivalent configurations do not depart from the scope of the present disclosure, and that various changes, substitutions, and modifications may be made in this specification without departing from the scope of the present disclosure.

**Claims**

1. A battery management device comprising:

   a memory configured to store one or more instructions; and
   a processor configured to execute the one or more instructions,
   wherein the processor is configured to:

   acquire a reference voltage for determining initial driving batteries among a plurality of batteries based on factors acquired from a plurality of cells included in each of the plurality of batteries; and
   manage a connection state of each of the plurality of batteries based on the reference voltage.

2. The battery management device of claim 1, wherein the factors include a nominal resistance of the plurality of cells, an allowable operating current of the plurality of cells, a first number of the plurality of cells connected in parallel, and an allowable voltage of the plurality of batteries.

3. The battery management device of claim 2, wherein the processor is configured to acquire the allowable voltage based on the nominal resistance, the operating current, and the first number.

4. The battery management device of claim 3, wherein the processor is configured to acquire the reference voltage based on the operating current, the first number, a second number of the plurality of cells connected in series, and the allowable voltage.

5. The battery management device of claim 1, wherein the processor is configured to determine whether to connect the at least one battery to the reference battery based on whether a difference between a first voltage of a reference battery and a second voltage of at least one battery different from the reference battery among the plurality of batteries is less than the reference voltage.

6. The battery management device of claim 5, wherein the processor is configured to connect the at least one battery to the reference battery based on the difference between the first voltage and the second voltage being less than the reference voltage.

7. The battery management device of claim 5, wherein the processor is configured to disconnect a connection between the at least one battery and the reference battery based on a difference between the first voltage and the second voltage being greater than or equal to the reference voltage.

8. The battery management device of claim 1, wherein the plurality of batteries include at least one of a plurality of battery packs, a plurality of battery racks, or any combination thereof.

9. A battery management method comprising:

   an operation of acquiring, by a processor, a reference voltage for determining initial driving batteries among a plurality of batteries based on factors acquired from a plurality of cells included in each of the plurality of batteries; and
   an operation of managing, by the processor, a connection state of each of the plurality of batteries based on the reference voltage.

10. The battery management method of claim 9, wherein the factors include a nominal resistance of the plurality of cells, an allowable operating current of the plurality of cells, a first number of the plurality of cells connected in parallel, and an allowable voltage of the plurality of batteries.

11. The battery management method of claim 10, further comprising:
    an operation of acquiring the allowable voltage based on the nominal resistance, the operating current, and the first number.

12. The battery management method of claim 11, further comprising:
an operation of acquiring the reference voltage based on the operating current, the first number, a second number of the plurality of cells connected in series, and the allowable voltage.

13. The battery management method of claim 9, further comprising:
an operation of determining whether to connect the at least one battery to the reference battery based on whether a difference between a first voltage of a reference battery and a second voltage of at least one battery different from the reference battery among the plurality of batteries is less than the reference voltage.

14. The battery management method of claim 13, further comprising:
an operation of connecting the at least one battery to the reference battery based on the difference between the first voltage and the second voltage being less than the reference voltage.

15. The battery management method of claim 13, further comprising:
an operation of disconnecting a connection between the at least one battery and the reference battery based on a difference between the first voltage and the second voltage being greater than or equal to the reference voltage.

FIG.1

BATTERY MANAGEMENT DEVICE
200

PROCESSOR
210

MEMORY
220

FIG.2

FIG.3

START

ACQUIRE REFERENCE VOLTAGE FOR DETERMINING INITIAL
DRIVING BATTERIES AMONG PLURALITY OF BATTERIES
BASED ON FACTORS ACQUIRED FROM PLURALITY
OF CELLS INCLUDED IN PLURALITY OF BATTERIES ⸺S401

MANAGE CONNECTION STATE OF EACH OF PLURALITY
OF BATTERIES BASED ON REFERENCE VOLTAGE ⸺S403

END

FIG.4

1100

1120                    1140

MEMORY          COMMUNICATION
                     I/F

MCU            INPUT/OUTPUT
                  I/F

1110              1130

FIG.5

## INTERNATIONAL SEARCH REPORT

| International application No. |
|---|
| **PCT/KR2025/009917** |

### A. CLASSIFICATION OF SUBJECT MATTER

**G01R 31/382**(2019.01)i; **G01R 31/396**(2019.01)i; **G01R 31/367**(2019.01)i; **G01R 31/36**(2006.01)i; **G01R 19/165**(2006.01)i; **H02J 7/00**(2006.01)i

According to International Patent Classification (IPC) or to both national classification and IPC

### B. FIELDS SEARCHED

Minimum documentation searched (classification system followed by classification symbols)

G01R 31/382(2019.01); G01R 19/00(2006.01); G01R 27/02(2006.01); G01R 35/00(2006.01); H01M 10/48(2006.01); H02J 13/00(2006.01); H02J 7/02(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 공칭 저항(nominal resistance), 전압(voltage), 평균(average), 배터리 랙(battery rack)

### C. DOCUMENTS CONSIDERED TO BE RELEVANT

| Category* | Citation of document, with indication, where appropriate, of the relevant passages | Relevant to claim No. |
|---|---|---|
| A | KR 10-2022-0146255 A (LG ENERGY SOLUTION, LTD.) 01 November 2022 (2022-11-01)<br>paragraphs [0039]-[0042], [0064], claim 1 and figure 1 | 1-15 |
| A | KR 10-2024-0069660 A (LG ENERGY SOLUTION, LTD.) 20 May 2024 (2024-05-20)<br>paragraphs [0046]-[0050], [0099]-[0101] and claim 1 | 1-15 |
| A | WO 2023-235723 A1 (WATLOW ELECTRIC MANUFACTURING COMPANY) 07 December 2023 (2023-12-07)<br>claims 1, 5-6, 16 | 1-15 |
| A | JP 2010-161918 A (O2 MICRO INC.) 22 July 2010 (2010-07-22)<br>paragraphs [0031]-[0035] and claims 1-7 | 1-15 |
| A | KR 10-2024-0069508 A (LG ENERGY SOLUTION, LTD.) 20 May 2024 (2024-05-20)<br>claims 1-3 and figures 1-2 | 1-15 |

☐ Further documents are listed in the continuation of Box C.　　☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **29 September 2025** | **30 September 2025** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**EP 4 764 533 A1**

## INTERNATIONAL SEARCH REPORT
### Information on patent family members

| International application No. |
| --- |
| **PCT/KR2025/009917** |

| Patent document cited in search report | | | Publication date (day/month/year) | Patent family member(s) | | | Publication date (day/month/year) |
| --- | --- | --- | --- | --- | --- | --- | --- |
| KR | 10-2022-0146255 | A | 01 November 2022 | None | | | |
| KR | 10-2024-0069660 | A | 20 May 2024 | AU | 2023-378169 | A1 | 16 May 2024 |
| | | | | CN | 120202420 | A | 24 June 2025 |
| | | | | EP | 4600678 | A1 | 13 August 2025 |
| | | | | KR | 10-2024-0069505 | A | 20 May 2024 |
| | | | | WO | 2024-101960 | A1 | 16 May 2024 |
| WO | 2023-235723 | A1 | 07 December 2023 | CN | 119301469 | A | 10 January 2025 |
| | | | | EP | 4533115 | A1 | 09 April 2025 |
| | | | | JP | 2025-519196 | A | 24 June 2025 |
| | | | | JP | 7728991 | B2 | 25 August 2025 |
| | | | | KR | 10-2025-0020495 | A | 11 February 2025 |
| | | | | KR | 10-2823320 | B1 | 19 June 2025 |
| | | | | TW | 202349012 | A | 16 December 2023 |
| | | | | TW | I864788 | B | 01 December 2024 |
| | | | | US | 12379442 | B2 | 05 August 2025 |
| | | | | US | 2025-0085376 | A1 | 13 March 2025 |
| | | | | WO | 2023-235723 | A9 | 07 November 2024 |
| JP | 2010-161918 | A | 22 July 2010 | CN | 101770685 | A | 07 July 2010 |
| | | | | CN | 101770685 | B | 13 March 2013 |
| | | | | CN | 101944640 | A | 12 January 2011 |
| | | | | CN | 101944640 | B | 12 December 2012 |
| | | | | EP | 2204874 | A2 | 07 July 2010 |
| | | | | EP | 2204874 | A3 | 13 October 2010 |
| | | | | EP | 2204874 | B1 | 29 May 2013 |
| | | | | EP | 2221942 | A2 | 25 August 2010 |
| | | | | EP | 2221942 | A3 | 01 October 2014 |
| | | | | JP | 2010-161922 | A | 22 July 2010 |
| | | | | JP | 5091219 | B2 | 05 December 2012 |
| | | | | JP | 5175309 | B2 | 03 April 2013 |
| | | | | TW | 201027344 | A | 16 July 2010 |
| | | | | TW | 201027880 | A | 16 July 2010 |
| | | | | TW | I399905 | B | 21 June 2013 |
| | | | | TW | I474172 | B | 21 February 2015 |
| | | | | US | 2010-0173180 | A1 | 08 July 2010 |
| | | | | US | 2011-0001357 | A1 | 06 January 2011 |
| | | | | US | 2011-0291618 | A1 | 01 December 2011 |
| | | | | US | 8022669 | B2 | 20 September 2011 |
| | | | | US | 8227944 | B2 | 24 July 2012 |
| | | | | US | 8237405 | B2 | 07 August 2012 |
| KR | 10-2024-0069508 | A | 20 May 2024 | AU | 2023-376088 | A1 | 15 May 2025 |
| | | | | CN | 120153270 | A | 13 June 2025 |
| | | | | EP | 4603855 | A1 | 20 August 2025 |
| | | | | WO | 2024-101694 | A1 | 16 May 2024 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020240130707